# EUROPEAN PATENT APPLICATION

(11) **EP 4 258 249 A1**
(43) Date of publication of application: **11.10.2023**
(21) Application number: 22739055.6
(22) Date of filing: 12.01.2022
(51) Int. Cl.: G09F 9/30

(54) **FOLDING DISPLAY DEVICE AND ELECTRONIC APPARATUS**

(30) Priority: 18.01.2021 CN 202110063298; 10.02.2021 CN 202110183466
(71) Applicant: Huawei Technologies Co., Ltd., Longgang District Shenzhen, Guangdong 518129 (CN)
(72) Inventor: XU, Fuguo, Shenzhen Guangdong 518129 (CN); WU, Kang, Shenzhen Guangdong 518129 (CN); LIANG, Xiao, Shenzhen Guangdong 518129 (CN); WANG, Jie, Shenzhen Guangdong 518129 (CN)
(74) Representative: MERH-IP Matias Erny Reichl Hoffmann Patentanwälte PartG mbB
(86) International application number: PCT/CN2022/071650
(87) International publication number: WO 2022/152177

(57) **Abstract**

A display apparatus (10) and an electronic device (100) including the display apparatus (10) are provided. The display apparatus (10) includes: a display panel (205), first ultra-thin glass (2031) and second ultra-thin glass (2032) that are stacked on two sides of the display panel (205), a first sticking layer (A4) between the display panel (205) and the first ultra-thin glass (2031), and a second sticking layer (A6) between the display panel (205) and the second ultra-thin glass (2032), where a stacked structure comprises the first ultra-thin glass (2031), the first sticking layer (A4), the display panel (205), the second sticking layer (A6), and the second ultra-thin glass (2032) is divided into a first region, a second region, and a folding region; the folding region is between the first region and the second region; and elastic moduli of the first sticking layer (A4) and the second sticking layer (A6) range from 15 Kpa to 100 Kpa. The display apparatus (10) and the electronic device (100) having the display apparatus (10) can resolve a bending and arching problem due to repeated folding of a foldable screen. This helps improve user experience.

## Description

This application claims priority to Chinese Patent Application No. 202110063298.0, filed with the China National Intellectual Property Administration on January 18, 2021 and entitled "FOLDABLE DISPLAY APPARATUS AND ELECTRONIC DEVICE", and claims priority to Chinese Patent Application No. 202110183466.X, filed with the China National Intellectual Property Administration on February 10, 2021 and entitled "FOLDABLE DISPLAY APPARATUS AND ELECTRONIC DEVICE", which are incorporated herein by reference in their entireties.

### TECHNICAL FIELD

Embodiments of this application relate to the field of display technologies, and in particular, to a foldable display apparatus and an electronic device.

### BACKGROUND

With the continuous development of technologies, foldable screens become a development trend of future mobile electronic products. A terminal using a foldable screen can be freely unfolded and folded, thereby improving user experience. A larger display area can be provided when the foldable screen is in an unfolded state, thereby improving a display effect. When the foldable screen is in a folded state, the terminal is convenient for a user to carry.

However, after repeated folding of the foldable screen, a folding region is bent and arched, resulting in poor flatness and affecting user experience.

### SUMMARY

This application provides a display apparatus and an electronic device having the display apparatus, to resolve a bending and arching problem due to repeated folding of a foldable screen. This helps improve user experience.

According to a first aspect, a foldable display apparatus is provided. The foldable display apparatus includes: a display panel, first ultra-thin glass and second ultra-thin glass that are stacked on two sides of the display panel, a first sticking layer between the display panel and the first ultra-thin glass, and a second sticking layer between the display panel and the second ultra-thin glass, where a stacked structure comprises the first ultra-thin glass, the first sticking layer, the display panel, the second sticking layer, and the second ultra-thin glass is divided into a first region, a second region, and a folding region; the folding region is between the first region and the second region; the first region and the second region are folded or unfolded along the folding region; and elastic moduli of the first sticking layer and the second sticking layer range from 15 Kpa to 100 Kpa.

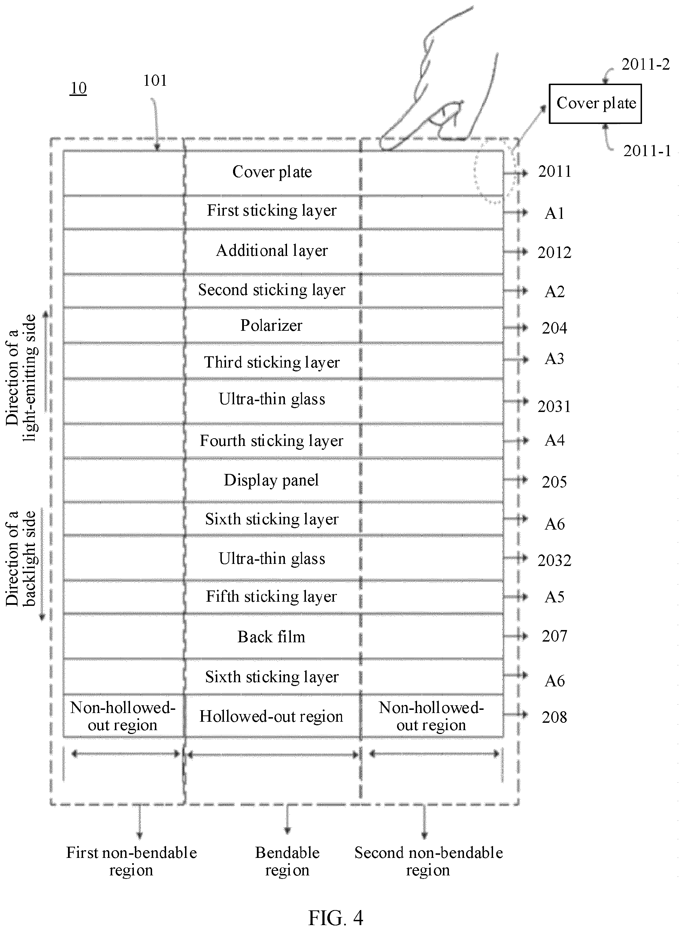

As shown in FIG. 4, ultra-thin glass 2031 and ultra-thin glass 2032 are on two sides of a display panel 205. The display panel 205, the ultra-thin glass 2031, and the ultra-thin glass 2032 present a stacked structure. A sticking layer A6 is between the display panel 205 and the ultra-thin glass 2032. A sticking layer A4 is between the display panel 205 and the ultra-thin glass 2031. The foldable display apparatus may be divided into a non-bendable region and a bendable region. The sticking layer A6 and the sticking layer A4 having low elastic moduli are used on two sides of the display panel 205. The sticking layer A6 and the sticking layer A4 are stacked on the two sides of the display panel. Because a sticking layer with a low elastic modulus has a lower shear stress value, using a sticking layer having a low elastic modulus can enhance foldable bending performance of a display module. Due to bending stress released in a bending process, the display module can recover a flattened state quickly. This can enhance the foldable bending performance of the display module, and avoid damage to the display module during folding.

Experiments show that a flattened angle, after static bending, of a display apparatus that does not use ultra-thin glass is 70°. After a first piece of ultra-thin glass is used above a display panel, and a second piece of ultra-thin glass is used under the display panel, a flattened angle, after static bending, of the display apparatus that uses the ultra-thin glass is 100°. This greatly reduces a bend and arch degree of the display apparatus.

With reference to the first aspect, in some possible implementations of the first aspect, an elastic modulus of the sticking layer is 30 Kpa, 45 Kpa, or 50 Kpa.

The sticking layer having the elastic modulus of 30 Kpa, 45 Kpa, or 50 Kpa is used, so that foldable bending performance of the display module is enhanced. Moreover, a bonding force of the sticking layer can be maintained, so that a bonding function can be implemented better to avoid a phenomenon that a functional layer of the display module falls off due to insecure bonding.

With reference to the first aspect, in some possible implementations of the first aspect, the elastic modulus of the first sticking layer is different from the elastic modulus of the second sticking layer.

The sticking layers with different elastic moduli are used on a side (for example, a backlight side) of the display panel, so that foldable bending performance of the display module can be enhanced. Moreover, a support force can be provided, after folding, for flattening of the display module.

With reference to the first aspect, in some possible implementations of the first aspect, the first sticking layer and/or the second sticking layer have/has different elastic moduli in the bendable region and the non-bendable region.

With reference to the first aspect, in some possible implementations of the first aspect, the first sticking layer and/or the second sticking layer have/has gradually changed elastic moduli (for example, an elastic modulus of the sticking layer is smaller at a position closer to the bendable region; or the elastic moduli of the sticking layer gradually change in a thickness direction).

With reference to the first aspect, in some possible implementations of the first aspect, the elastic moduli/elastic modulus of the first sticking layer and/or the second sticking layer in the bendable region are/is less than the elastic moduli/elastic modulus of the first sticking layer and/or the second sticking layer in the non-bendable region.

The sticking layers having different elastic moduli are used in the bendable region and the non-bendable region, so that foldable bending performance of the display module can be enhanced. Moreover, a support force required for recovering a flattened state after bending of the display module can be provided.

With reference to the first aspect, in some possible implementations of the first aspect, thicknesses of the first sticking layer and the second sticking layer are at least 15 um.

With reference to the first aspect, in some possible implementations of the first aspect, the thicknesses of the first sticking layer and the second sticking layer on the two sides of the display panel range from 15 um to 45 um, and the sticking layers are stacked on the two sides of the display panel.

With reference to the first aspect, in some possible implementations of the first aspect, the first sticking layer and the second sticking layer are sticking layers having thicknesses of 75 um, 100 um, 125 um, or 150 um. In this way, foldable bending performance of the display module can be enhanced without significantly increasing a thickness of the display module. This maintains good user experience.

With reference to the first aspect, in some possible implementations of the first aspect, the first sticking layer and/or the second sticking layer have/has different thicknesses in the bendable region and the non-bendable region.

Optionally, the thicknesses/thickness of the first sticking layer and/or the second sticking layer in the bendable region are/is greater than the thicknesses/thickness of the first sticking layer and/or the second sticking layer in the non-bendable region.

Optionally, the thicknesses of the first sticking layer and/or the second sticking layer change gradually from the bendable region to the non-bendable region. For example, a thickness of the sticking layer is larger at a position closer to the bendable region.

Optionally, the thicknesses of the first sticking layer and/or the second sticking layer change in a stepped manner from the bendable region to the non-bendable region.

When the sticking layer having different thicknesses in the bendable region and the non-bendable region is used, foldable bending performance of the display module can be enhanced without significantly increasing a thickness of the display module. This maintains good user experience.

When the sticking layer whose thicknesses change gradually in the bendable region and the non-bendable region is used, shear stress can change gradually in the bendable region and the non-bendable region. This avoids damage to a display module caused by a sudden change of stress on the display panel in the bendable region and the non-bendable region during folding of the foldable display module.

With reference to the first aspect, in some possible implementations of the first aspect, the foldable display apparatus further includes: a third sticking layer and a back film that are stacked on a same side of the display panel, where both the third sticking layer and the back film are between the display panel and the first ultra-thin glass; and the third sticking layer is between the back film and the first ultra-thin glass.

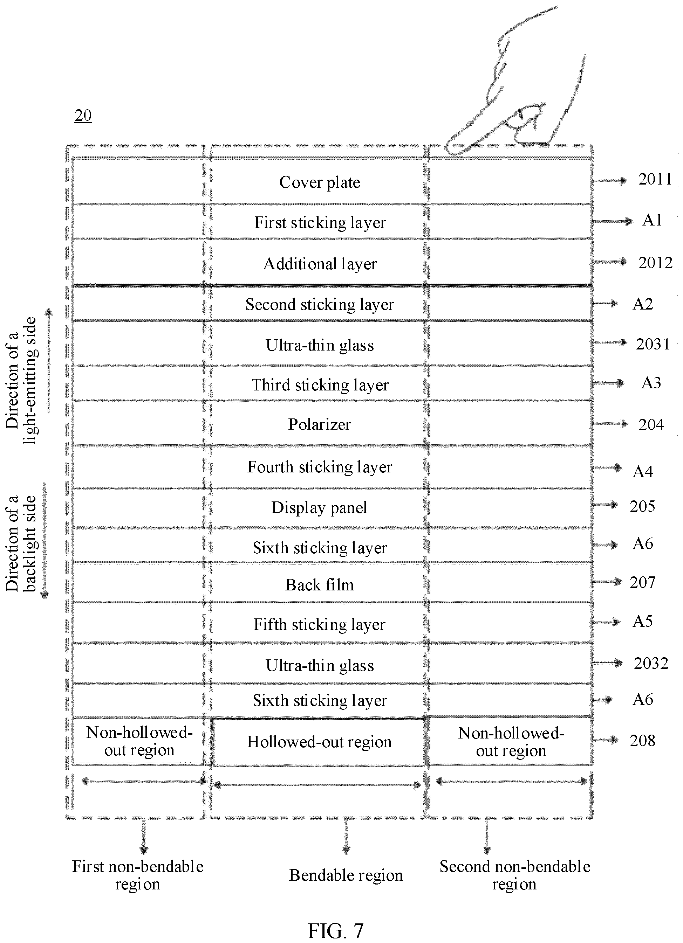

For example, as shown in FIG. 7, a sticking layer A5 and a back film 207 are stacked on a same side of the display panel 205. Both the sticking layer A5 and the back film 207 are between the display panel 205 and the ultra-thin glass 2032. The sticking layer A5 is between the back film 207 and the ultra-thin glass 2032.

The back film is placed between the ultra-thin glass and the display panel. The ultra-thin glass can provide a flattening force for the display panel, so that the display panel is kept flat after bending. In addition, the back film can be protected to prevent the back film from being damaged. In other words, the ultra-thin glass can protect both the back film and the display panel, so that impact resistance of the display apparatus can be improved.

With reference to the first aspect, in some possible implementations of the first aspect, the foldable display apparatus further includes a fourth sticking layer and a polarizer that are stacked on a same side of the display panel, where both the fourth sticking layer and the polarizer are between the display panel and the second ultra-thin glass, and the fourth sticking layer is between the polarizer and the second ultra-thin glass.

For example, as shown in FIG. 7, a sticking layer A3 and a polarizer 204 are stacked on a same side of the display panel 205. Both the sticking layer A3 and the polarizer 204 are between the display panel 205 and the ultra-thin glass 2031. The sticking layer A3 is between the polarizer 204 and the ultra-thin glass 2031.

The polarizer is placed between the ultra-thin glass and the display panel. The ultra-thin glass can provide a flattening force for the display panel, so that the display panel is kept flat after bending. In addition, the polarizer can be protected by using an advantage of high hardness of the ultra-thin glass, to prevent the polarizer from being damaged.

With reference to the first aspect, in some possible implementations of the first aspect, the foldable display apparatus further includes a touch layer and a fifth sticking layer that are stacked on a same side of the display panel, where the touch layer and the fifth sticking layer are between the second ultra-thin glass and the polarizer, and the fifth sticking layer is between the second ultra-thin glass and the touch layer.

For example, as shown in FIG. 7, a touch layer (not shown in the figure) and a sticking layer (not shown in the figure) are stacked on a same side of the display panel 205. The touch layer and the sticking layer may be between the ultra-thin glass 2031 and the polarizer 204. The sticking layer may be between the ultra-thin glass 2031 and the touch layer.

The touch layer is placed on a light-emitting side of the polarizer 204, so that the touch layer is closer to a cover plate 2011. This enables a user to obtain better touch experience.

With reference to the first aspect, in some possible implementations of the first aspect, the display panel may include an encapsulation layer, an organic light-emitting component layer, and a touch layer, where the encapsulation layer, the organic light-emitting component layer, and the touch layer form a stacked structure.

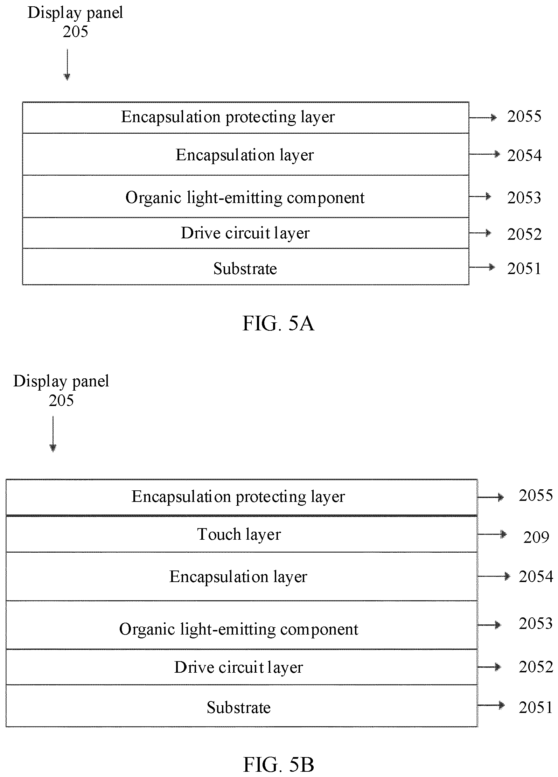

For example, as shown in FIG. 5B, the display panel 205 may include an encapsulation layer 2054, an organic light-emitting component layer 2053, and a touch layer 209.

The touch layer is integrated into the display panel, so that a thickness of a foldable-screen display module can be effectively reduced. Moreover, damage to the display module can be avoided during bending.

With reference to the first aspect, in some possible implementations of the first aspect, the touch layer may include third ultra-thin glass.

Compared with a touch layer integrated with built-in PET (Polyethylene Terephthalate, polyethylene terephthalate), a touch layer integrated with ultra-thin glass may have a better drop ball-resistance capability and a better strain force, which can avoid damage during bending.

With reference to the first aspect, in some possible implementations of the first aspect, values of refractive indexes of the first sticking layer, the second sticking layer, the third sticking layer, the fourth sticking layer, and the fifth sticking layer range from 1.5 to 1.8.

A large amount of an organic polymer film material, for example, CPI (clear Polyimide, clear polyimide) is used in the foldable display apparatus, where a refractive index of the CPI is 1.6. A refractive index of an existing sticking layer is 1.47, and the refractive index of the sticking layer does not match a refractive index of another organic polymer film material. As a result, reflectivity of each boundary surface of stacked layers of a display module increases, a transmittance degree decreases, and light-emitting efficiency of the display apparatus is greatly affected. Optionally, a sticking layer having a refractive index of 1.5 is selected, so that light transmittance of the display module can be greatly improved, and optical reflectivity of the display module can be reduced. Optionally, a value of the refractive index of the sticking layer ranges from 1.5 to 1.8. In some embodiments, for the sticking layers in the foregoing embodiment, the refractive indexes of the sticking layers may be different.

With reference to the first aspect, in some possible implementations of the first aspect, the polarizer is a coatable polarizing plate.

When the coatable polarizing plate is used, a thickness of the display apparatus can be effectively reduced. This improves user experience.

With reference to the first aspect, in some possible implementations of the first aspect, the first sticking layer, the second sticking layer, the third sticking layer, the fourth sticking layer, and the fifth sticking layer are foldable optically clear adhesive.

With reference to the first aspect, in some possible implementations of the first aspect, the foldable display apparatus further includes a support structure and a sixth sticking layer, where the support structure, the sixth sticking layer, and the first ultra-thin glass form a stacked structure, both the support structure and the sixth sticking layer are on a same side of the first ultra-thin glass, and the sixth sticking layer is between the support structure and the first ultra-thin glass.

With reference to the first aspect, in some possible implementations of the first aspect, the support structure includes a hollowed-out region, a first non-hollowed-out region, and a second non-hollowed-out region, where the hollowed-out region is between the first non-hollowed-out region and the second non-hollowed-out region.

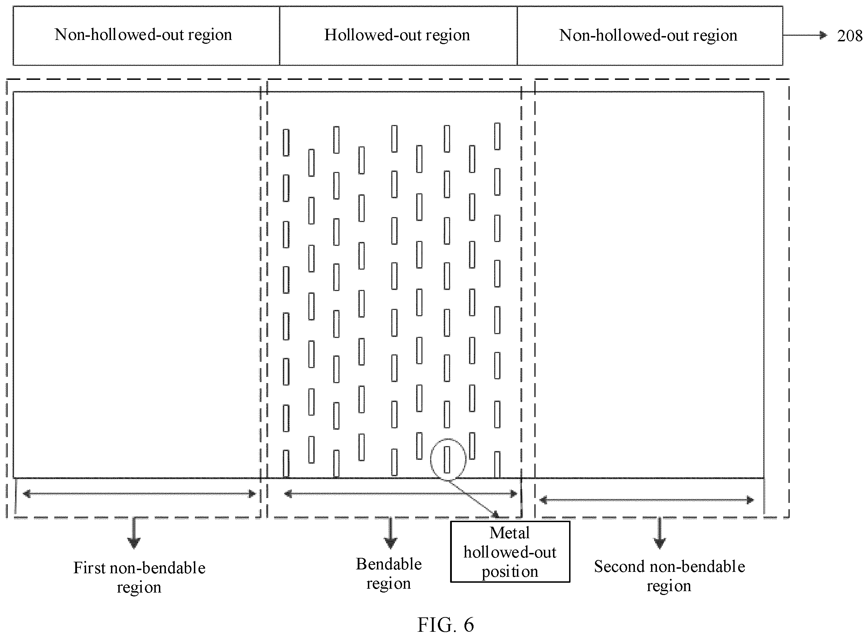

For example, as shown in FIG. 6, a hollowed-out structure is used in a bendable region, and a non-hollowed-out structure is used in a non-bendable region (including a first non-bendable region and a second non-bendable region) to support a display module. Therefore, on the premise that a requirement for a bendable feature is met, a strong support force can be provided for the non-bendable region and the bendable region. This reduces a bend and arch degree, and increases flatness of the display module that is unfolded after folding.

With reference to the first aspect, in some possible implementations of the first aspect, a thickness of the support structure ranges from 50 um to 200 um.

With reference to the first aspect, in some possible implementations of the first aspect, the support structure may be a metal structure.

With reference to the first aspect, in some possible implementations of the first aspect, a pattern, also referred to as a hollowed-out pattern, of the hollowed-out region in the support structure may be one or a combination of a plurality of shapes such as a rectangle, a triangle, and a circle.

With reference to the first aspect, in some possible implementations of the first aspect, the foldable display apparatus further includes a support component, where the support component is between the back film and the support structure, and the support component, the back film, and the support structure form a stacked structure.

With reference to the first aspect, in some possible implementations of the first aspect, the support component may be at least one of a SUS (Steel Use Stainless) steel sheet, a copper sheet, an aluminum sheet, or a metal alloy.

With reference to the first aspect, in some possible implementations of the first aspect, a thickness of the support component is 30 um.

According to a second aspect, a foldable electronic device is provided. The electronic device includes the display apparatus according to the first aspect.

### BRIEF DESCRIPTION OF DRAWINGS

FIG. 1 is a schematic diagram of a structure of an electronic device according to an embodiment of this application;
FIG. 2 is a block diagram of a software structure of an electronic device according to an embodiment of this application;
FIG. 3A and FIG. 3B are schematic diagrams of a foldable electronic device including a foldable display apparatus according to an embodiment of this application;
FIG. 3C and FIG. 3D are schematic diagrams of a foldable electronic device having a bending and arching problem according to an embodiment of this application;
FIG. 4 is a schematic diagram of a foldable display apparatus according to an embodiment of this application;
FIG. 5A and FIG. 5B are schematic diagrams of a display panel according to an embodiment of this application;
FIG. 6 is a schematic diagram of a support structure according to an embodiment of this application; and
FIG. 7 is a schematic diagram of another foldable display apparatus according to an embodiment of this application.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

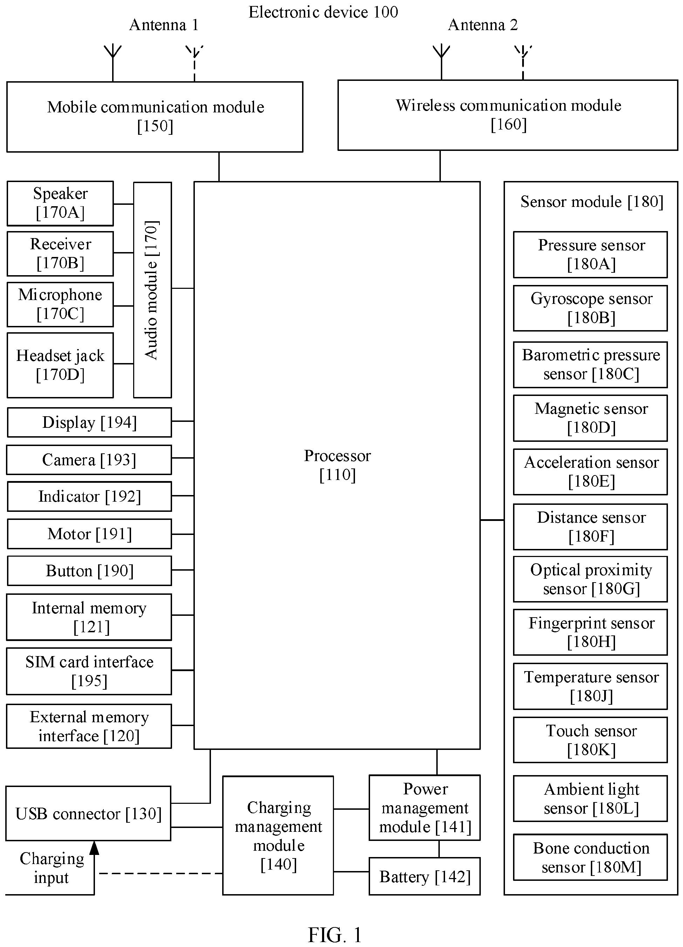

FIG. 1 is a schematic diagram of a structure of an electronic device 100.

The electronic device 100 may include at least one of a mobile phone, a tablet computer, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a wearable device, an on-board device, a smart home device, or a smart city device. A specific type of the electronic device 100 is not specially limited in embodiments of this application.

The electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identity module (subscriber identity module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It may be understood that the structure illustrated in this embodiment of this application does not constitute a specific limitation on the electronic device 100. In some other embodiments of this application, the electronic device 100 may include more or fewer components than those shown in the figure, or some components may be combined or split, or there may be a different component arrangement. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

The processor may generate an operation control signal based on instruction operation code and a time sequence signal, to complete control of instruction reading and instruction execution.

The processor 110 may be further provided with a memory, configured to store instructions and data. In some embodiments, the memory in the processor 110 may be a cache. The memory may store instructions or data that are/is used by the processor 110 or that are/is used frequently. If the processor 110 needs to use the instructions or data again, the processor 110 may directly invoke the instructions or data from the memory. This avoids repeated access, and reduces waiting time of the processor 110, thereby improving system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like. The processor 110 may be connected to modules such as a touch sensor, an audio module, a wireless communication module, a display, and a camera through at least one type of the foregoing interfaces.

It may be understood that an interface connection relationship, between modules, illustrated in this embodiment of this application is merely an example for description, and does not constitute a limitation on the structure of the electronic device 100. In some other embodiments of this application, the electronic device 100 may alternatively use an interface connection manner different from that in this embodiment, or use a combination of a plurality of interface connection manners.

The USB interface 130 is an interface conforming to a USB standard specification, may be configured to connect the electronic device 100 and a peripheral device, and may be specifically a mini USB connector, a micro USB connector, a USB Type-C connector, or the like. The USB interface130 may be configured to: connect to a charger, so that the charger charges the electronic device 100; connect to another electronic device, so that data is transmitted between the electronic device 100 and the another electronic device; or connect to a headset, so that the headset outputs audio stored in the electronic device. The connector may be further configured to connect to another electronic device, for example, a VR device. In some embodiments, a standard specification of the universal serial bus may be USB1.x, USB2.0, USB3.x, and USB4.

The charging management module 140 is configured to receive a charging input of the charger. The charger may be a wireless charger or a wired charger. In some embodiments of wired charging, the charging management module 140 may receive a charging input from the wired charger through the USB interface 130. In some embodiments of wireless charging, the charging management module 140 may receive a wireless charging input through a wireless charging coil of the electronic device 100. The charging management module 140 may further supply power to the electronic device by using the power management module 141 while charging the battery 142.

The power management module 141 is configured to connect the battery 142, the charging management module 140, and the processor 110. The power management module 141 receives an input from the battery 142 and/or the charging management module 140, and supplies power to the processor 110, the internal memory 121, the display 194, the camera 193, the wireless communication module 160, and the like. The power management module 141 may be further configured to monitor parameters such as a battery capacity, a quantity of battery cycles, and a battery health status (electric leakage and impedance). In some other embodiments, the power management module 141 may alternatively be disposed in the processor 110. In some other embodiments, the power management module 141 and the charging management module 140 may alternatively be disposed in a same device.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device 100 may be configured to cover one or more communication bands. Different antennas may be multiplexed to improve antenna utilization. For example, the antenna 1 may be multiplexed as a diversity antenna in a wireless local area network. In some other embodiments, the antenna may be used in combination with a tuning switch.

The mobile communication module 150 may provide a wireless communication solution that is applied to the electronic device 100 and that includes 2G/3G/4G/5G. The mobile communication module 150 may include at least one filter, a switch, a power amplifier, a low noise amplifier (low noise amplifier, LNA), and the like. The mobile communication module 150 may receive an electromagnetic wave through the antenna 1, and perform processing such as filtering and amplification on the received electromagnetic wave, and transmit a processed electromagnetic wave to the modem processor for demodulation. The mobile communication module 150 may further amplify a signal modulated by the modem processor, and convert, through the antenna 1, an amplified signal into an electromagnetic wave for radiation. In some embodiments, at least some functional modules of the mobile communication module 150 may be disposed in the processor 110. In some embodiments, at least some functional modules of the mobile communication module 150 may be disposed in the same device as at least some modules of the processor 110. The modem processor may include a modulator and a demodulator. The modulator is configured to modulate a to-be-sent low-frequency baseband signal into a medium-high frequency signal. The demodulator is configured to demodulate the received electromagnetic wave signal into a low-frequency baseband signal. Then, the demodulator transmits the low-frequency baseband signal obtained through demodulation to the baseband processor for processing. The baseband processor processes the low-frequency baseband signal, and then transfers a processed signal to the application processor. The application processor outputs a sound signal by using an audio device (which is not limited to the speaker 170A, the receiver 170B, or the like), or displays an image or a video by using the display 194. In some embodiments, the modem processor may be an independent device. In some other embodiments, the modem processor may be independent of the processor 110, and is disposed in the same device as the mobile communication module 150 or another functional module.

The wireless communication module 160 may provide a wireless communication solution that is applied to the electronic device 100 and that includes a wireless local area network (wireless local area network, WLAN) (for example, a wireless fidelity (wireless fidelity, Wi-Fi) network), Bluetooth (Bluetooth, BT), Bluetooth Low Energy (Bluetooth Low Energy, BLE), Ultra Wide Band (Ultra Wide Band, UWB), a global navigation satellite system (global navigation satellite system, GNSS), frequency modulation (frequency modulation, FM), a near field communication (near field communication, NFC) technology, an infrared (infrared, IR) technology, or the like. The wireless communication module 160 may be one or more devices integrating at least one communication processing module. The wireless communication module 160 receives an electromagnetic wave through the antenna 2, performs frequency modulation and filtering on an electromagnetic wave signal, and sends a processed signal to the processor 110. The wireless communication module 160 may further receive a to-be-sent signal from the processor 110, perform frequency modulation and amplification on the signal, and convert, through the antenna 2, a frequency-modulated and amplified signal into an electromagnetic wave for radiation.

In some embodiments, in the electronic device 100, the antenna 1 and the mobile communication module 150 are coupled, and the antenna 2 and the wireless communication module 160 are coupled, so that the electronic device 100 can communicate with a network and another electronic device by using a wireless communication technology. The wireless communication technology may include global system for mobile communications (global system for mobile communications, GSM), general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, GNSS, WLAN, NFC, FM, IR, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation system, SBAS).

The electronic device 100 may implement a display function by using the GPU, the display 194, the application processor, and the like. The GPU is a microprocessor for image processing, and is connected to the display 194 and the application processor. The GPU is configured to perform mathematical and geometric calculations for graphics rendering. The processor 110 may include one or more GPUs that execute program instructions to generate or change display information.

The display 194 is configured to display an image, a video, and the like. The display 194 includes a display panel. The display panel may use a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a mini-LED, a micro-LED, a micro-OLED, a quantum dot light-emitting diode (quantum dot light-emitting diode, QLED), or the like. In some embodiments, the electronic device 100 may include one or more displays 194.

In some embodiments, the display 194 may be an organic light-emitting diode (Organic Light-Emitting Diode, OLED) display, or may be a liquid crystal display (Liquid Crystal Display, LCD). It should be understood that the display 194 may include a display component and a touch component. The display component is configured to output display content to a user. The touch component is configured to receive a touch event entered by the user on the display 194 In some embodiments, the display 194 is a foldable display. In some embodiments, the display 194 may be a flexible OLED (Organic Light-Emitting Diode) display. In some embodiments, the display 194 may alternatively be a flexible OLCD (Organic Liquid-Crystal Display).

The electronic device 100 may implement an image shooting function by using a camera module 193, the ISP, the video codec, the GPU, the display 194, the application processor AP, the neural-network processing unit NPU, and the like.

The camera module 193 may be configured to collect color image data and depth data of a photographed object. The ISP may be configured to process the color image data collected by the camera module 193. For example, when a shutter is opened for taking a photo, light is transmitted to an image sensor of a camera through a lens, and a light signal is converted into an electrical signal. The image sensor of the camera transmits the electrical signal to the ISP for processing, so that the electrical signal is converted into an image visible to eyes. The ISP may further perform algorithm optimization on noise, luminance, and skin tone of the image. The ISP may further optimize parameters such as exposure and color temperature of a shooting scene. In some embodiments, the ISP may be disposed in the camera module 193.

In some embodiments, the camera module 193 may include a color camera module and a 3D sensing module.

In some embodiments, a photosensitive element of a camera of the color camera module may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP for converting the electrical signal into a digital image signal. The ISP outputs the digital image signal to the DSP for processing. The DSP converts the digital image signal into an image signal in a standard format such as an RGB format or a YUV format.

In some embodiments, the 3D sensing module may be a time of flight (time of flight, TOF) 3D sensing module or a structured light (structured light) 3D sensing module. Structured light 3D sensing is an active depth sensing technology. Basic components of the structured light 3D sensing module may include an infrared (Infrared) transmitter, an IR camera module, and the like. A working principle of the structured light 3D sensing module is to first emit a light spot of a specific pattern (pattern) to a photographed object, and then receive coding of the light spot pattern (light coding) on a surface of the object, to compare the light spot with an original projected light spot, and calculate three-dimensional coordinates of the object according to a triangulation principle. The three-dimensional coordinates include a distance between the electronic device 100 and the photographed object. TOF 3D sensing may be an active depth sensing technology. Basic components of the TOF 3D sensing module may include an infrared (Infrared) transmitter, an IR camera module, and the like. A working principle of the TOF 3D sensing module is to calculate a distance (that is, a depth) between the TOF 3D sensing module and a photographed object by using an infrared refraction time, to obtain a 3D depth-of-field image.

The structured light 3D sensing module may also be used in fields such as facial recognition, a somatic game console, and industrial machine vision detection. The TOF 3D sensing module may also be used in fields such as a game console and augmented reality (augmented reality, AR)/virtual reality (virtual reality, VR).

In some other embodiments, the camera module 193 may further include two or more cameras. The two or more cameras may include a color camera. The color camera may be configured to collect color image data of the photographed object. The two or more cameras may collect depth data of the photographed object by using a stereo vision (stereo vision) technology. The stereo vision technology is based on a principle of a parallax of human eyes. Under a natural light source, two or more cameras are used to photograph an image of a same object from different angles, and then an operation such as a triangulation method is performed to obtain distance information, that is, depth information, between the electronic device 100 and the photographed object.

In some embodiments, the electronic device 100 may include one or more camera modules 193. Specifically, the electronic device 100 may include one front-facing camera module 193 and one rear-facing camera module 193. The front-facing camera module 193 may be usually configured to collect color image data and depth data of a photographer facing the display 194. The rear-facing camera module may be configured to collect color image data and depth data of a photographed object (such as a character or a scenery) facing the photographer.

In some embodiments, the CPU, the GPU, or the NPU in the processor 110 may process the color image data and the depth data that are collected by the camera module 193. In some embodiments, the NPU may identify, by using a neural network algorithm based on a skeleton joint identification technology, for example, a convolutional neural network (CNN) algorithm, color image data collected by the camera module 193 (specifically, the color camera module), to determine skeleton joints of a photographed character. The CPU or the GPU may also run a neural network algorithm to determine the skeleton joints of the photographed character based on the color image data. In some embodiments, the CPU, the GPU, or the NPU may be further configured to: determine a figure (for example, a body proportion and a fatness and thinness degree of a body part between skeleton joints) of the photographed character based on depth data collected by the camera module 193 (which may be the 3D sensing module) and the identified skeleton joints, further determine a body beautification parameter for the photographed character, and finally process a photographed image of the photographed character based on the body beautification parameter, so that a body shape of the photographed character in the photographed image is beautified. In a subsequent embodiment, how to perform body shaping processing on an image of a photographed character based on color image data and depth data that are collected by the camera module 193 is described in detail. Details are not described herein.

The digital signal processor is configured to process a digital signal, and may further process another digital signal. For example, when the electronic device 100 selects a frequency, the digital signal processor is configured to perform Fourier transform and the like on frequency energy.

The video codec is configured to compress or decompress a digital video. The electronic device 100 may support one or more types of video codecs. In this way, the electronic device 100 may play back or record videos in a plurality of coding formats, for example, moving picture experts group (moving picture experts group, MPEG)-1, MPEG-2, MPEG-3, and MPEG-4.

The NPU is a neural-network (neural-network, NN) computing processor, quickly processes input information by referring to a structure of a biological neural network, for example, by referring to a mode of transmission between human brain neurons, and may further continuously perform self-learning. Applications such as intelligent cognition of the electronic device 100 may be implemented through the NPU, for example, image recognition, facial recognition, voice recognition, and text understanding.

The external memory interface 120 may be configured to connect to an external memory card, for example, a micro SD card, to extend a storage capability of the electronic device 100. The external memory card communicates with the processor 110 through the external memory interface 120, to implement a data storage function. For example, files such as music and a video are stored into the external memory card; or files such as music and a video are transferred from the electronic device to the external memory card.

The internal memory 121 may be configured to store computer executable program code. The executable program code includes an instruction. The internal memory 121 may include a program storage area and a data storage area. The program storage area may store an operating system, an application required by at least one function (for example, a voice play function and an image play function), and the like. The data storage area may store data (such as audio data and a phone book) created during use of the electronic device 100, and the like. In addition, the internal memory 121 may include a high-speed random access memory, and may further include a nonvolatile memory, for example, at least one magnetic disk storage device, a flash memory, a universal flash storage (universal flash storage, UFS), and the like. The processor 110 runs the instructions stored in the internal memory 121 and/or the instructions stored in the memory disposed in the processor, to perform various function methods or data processing of the electronic device 100.

The electronic device 100 may use the audio module 170, the speaker 170A, the receiver 170B, the microphone 170C, the headset jack 170D, the application processor, and the like to implement an audio function, for example, music playback and sound recording.

The audio module 170 is configured to convert digital audio information into an analog audio signal for output, and is also configured to convert an analog audio input into a digital audio signal. The audio module 170 may be further configured to encode and decode an audio signal. In some embodiments, the audio module 170 may be disposed in the processor 110, or some functional modules of the audio module 170 are disposed in the processor 110.

The speaker 170A, also referred to as a "loudspeaker", is configured to convert an audio electrical signal into a sound signal. The electronic device 100 may be used to listen to music or output an audio signal of a hands-free call through the speaker 170A.

The receiver 170B, also referred to as an "earpiece", is configured to convert an audio electrical signal into a sound signal. When a call is answered or voice information is received through the electronic device 100, the receiver 170B may be put close to a human ear to listen to a voice.

The microphone 170C, also referred to as a "mike" or a "mic", is configured to convert a sound signal into an electrical signal. When making a call or sending a voice message, a user may make a sound near the microphone 170C through the mouth of the user, to input a sound signal to the microphone 170C. The electronic device 100 may be provided with at least one microphone 170C. In some other embodiments, the electronic device 100 may be provided with two microphones 170C, to collect a sound signal and further implement a noise reduction function. In some other embodiments, the electronic device 100 may alternatively be provided with three, four, or more microphones 170C, to collect a sound signal, implement noise reduction, identify a sound source, implement a directional recording function, and the like.

The headset jack 170D is configured to connect to a wired headset. The headset jack 170D may be the USB interface 130, or may be a 3.5 mm open mobile electronic device platform (open mobile terminal platform, OMTP) standard interface or a cellular telecommunications industry association of the USA (cellular telecommunications industry association of the USA, CTIA) standard interface.

The pressure sensor 180A is configured to sense a pressure signal, and can convert the pressure signal into an electrical signal. In some embodiments, the pressure sensor 180A may be disposed on the display 194. There are many types of pressure sensors 180A, for example, a resistive pressure sensor, an inductive pressure sensor, and a capacitive pressure sensor. The capacitive pressure sensor may include at least two parallel plates having conductive materials. When a force is applied to the pressure sensor 180A, capacitance between electrodes changes. The electronic device 100 determines pressure intensity based on the change in the capacitance. When a touch operation is performed on the display 194, the electronic device 100 detects intensity of the touch operation by using the pressure sensor 180A. The electronic device 100 may further calculate a touch position based on a detection signal of the pressure sensor 180A. In some embodiments, touch operations that are performed at a same touch position but have different touch operation intensity may correspond to different operation instructions. For example, when a touch operation whose touch operation intensity is less than a first pressure threshold is performed on an SMS message application icon, an instruction for viewing an SMS message is executed. When a touch operation whose touch operation intensity is greater than or equal to the first pressure threshold is performed on the SMS message application icon, an instruction for creating a new SMS message is executed.

The gyroscope sensor 180B may be configured to determine a motion posture of the electronic device 100. In some embodiments, angular velocities of the electronic device 100 around three axes (namely, axes x, y, and z) may be determined by using the gyroscope sensor 180B. The gyroscope sensor 180B may be configured to implement image stabilization during photographing. For example, when the shutter is opened, the gyroscope sensor 180B detects a shaking angle of the electronic device 100, and calculates, based on the angle, a distance for which a lens module needs to compensate, so as to control the lens to move reversely, thereby canceling shaking of the electronic device 100, and implementing image stabilization. The gyroscope sensor 180B may also be used in a navigation scenario and a somatic game scenario.

The barometric pressure sensor 180C is configured to measure a barometric pressure. In some embodiments, the electronic device 100 calculates an altitude based on the barometric pressure measured by the barometric pressure sensor 180C, to assist in positioning and navigation.

The magnetic sensor 180D includes a Hall sensor. The electronic device 100 may detect opening and closing of a flap/leather case by using the magnetic sensor 180D. When the electronic device is a foldable electronic device, the magnetic sensor 180D may be configured to detect folding or unfolding, or a folding angle of the electronic device. In some embodiments, when the electronic device 100 is a clamshell phone, the electronic device 100 may detect opening and closing of a flap by using the magnetic sensor 180D. Further, a feature such as automatic unlocking upon opening of the flap is set based on a detected opening or closing state of the leather case or a detected opening or closing state of the flap.

The acceleration sensor 180E may detect accelerations of the electronic device 100 in various directions (generally along three axes), may detect a magnitude and a direction of gravity when the electronic device 100 is static, and may be further configured to recognize a posture of the electronic device, thereby being used in applications such as screen switching between a landscape mode and a portrait mode, a pedometer, or another application.

The distance sensor 180F is configured to measure a distance. The electronic device 100 may measure a distance in an infrared manner or a laser manner. In some embodiments, the electronic device 100 may measure a distance in a photographing scenario by using the distance sensor 180F, to implement quick focusing.

The optical proximity sensor 180G may include, for example, a light emitting diode (LED) and an optical detector, for example, a photodiode. The light-emitting diode may be an infrared light-emitting diode. The electronic device 100 emits infrared light by using the light-emitting diode. The electronic device 100 detects infrared reflected light from a nearby object by using the photodiode. When intensity of the detected reflected light is greater than a threshold, the electronic device 100 may determine that there is an object near the electronic device 100. When intensity of the detected reflected light is less than the threshold, the electronic device 100 may determine that there is no object near the electronic device 100. The electronic device 100 may detect, by using the optical proximity sensor 180G, that the user holds the electronic device 100 close to an ear for a call, to automatically turn off a screen for power saving. The optical proximity sensor 180G may also be used in a leather case mode or a pocket mode to automatically unlock or lock the screen.

The ambient light sensor 180L may be configured to sense ambient light brightness. The electronic device 100 may adaptively adjust brightness of the display 194 based on the sensed ambient light brightness. The ambient light sensor 180L may be further configured to automatically adjust a white balance during photographing. The ambient light sensor 180L may further cooperate with the optical proximity sensor 180G in detecting whether the electronic device 100 is blocked, for example, the electronic device is in a pocket. When it is detected that the electronic device is blocked or in a pocket, some functions (for example, a touch function) may be disabled to prevent a misoperation.

The fingerprint sensor 180H is configured to collect a fingerprint. The electronic device 100 may use a feature of the collected fingerprint to implement fingerprint-based unlocking, application lock access, fingerprint-based photographing, fingerprint-based call answering, and the like.

The temperature sensor 180J is configured to detect a temperature. In some embodiments, the electronic device 100 executes a temperature processing policy based on the temperature detected by the temperature sensor 180J. For example, when the temperature detected by the temperature sensor 180J exceeds a threshold, the electronic device 100 lowers performance of the processor, to reduce power consumption of the electronic device and implement thermal protection. In some other embodiments, when the temperature detected by the temperature sensor 180J is below another threshold, the electronic device 100 heats the battery 142. In some other embodiments, when the temperature is below still another threshold, the electronic device 100 may boost an output voltage of the battery 142.

The touch sensor 180K is also referred to as a "touch component". The touch sensor 180K may be disposed on the display 194. The touch sensor 180K and the display 194 constitute a touchscreen, which is also referred to as a "touch screen". The touch sensor 180K is configured to detect a touch operation performed on or near the touch sensor 180K. The touch sensor may transfer the detected touch operation to the application processor to determine a type of a touch event. A visual output related to the touch operation may be provided on the display 194. In some other embodiments, the touch sensor 180K may alternatively be disposed on a surface of the electronic device 100 at a position different from that of the display 194.

The bone conduction sensor 180M may obtain a vibration signal. In some embodiments, the bone conduction sensor 180M may obtain a vibration signal of a vibration bone of a human vocal-cord part. The bone conduction sensor 180M may also be in contact with a human pulse, to receive a blood pressure beating signal. In some embodiments, the bone conduction sensor 180M may also be disposed in the headset, to constitute a bone conduction headset. The audio module 170 may parse out a voice signal based on the vibration signal that is of the vibration bone of the vocal-cord part and that is obtained by the bone conduction sensor 180M, to implement a voice function. The application processor may parse out heart rate information based on the blood pressure beat signal obtained by the bone conduction sensor 180M, to implement a heart rate detection function.

The button 190 may include a power button, a volume button, and the like. The button 190 may be a mechanical button, or may be a touch button. The electronic device 100 may receive a button input, and generate a button signal input related to a user setting and function control of the electronic device 100.

The motor 191 may generate a vibration prompt. The motor 191 may be configured to provide an incoming call vibration prompt or a touch vibration feedback. For example, touch operations performed on different applications (for example, photographing and audio playing) may correspond to different vibration feedback effects. For touch operations performed on different areas of the display 194, the motor 191 may also produce different vibration feedback effects correspondingly. Different application scenarios (for example, a time reminder, information receiving, an alarm clock, and a game) may also correspond to different vibration feedback effects. A touch vibration feedback effect may be further customized.

The indicator 192 may be an indicator light, and may be configured to indicate a charging status and a power change, or may be configured to indicate a message, a missed call, a notification, and the like.

The SIM card interface 195 is configured to connect to a SIM card. The SIM card may be inserted into the SIM card interface 195 or removed from the SIM card interface 195, to implement contact with or separation from the electronic device 100. The electronic device 100 may support one or more SIM card interfaces. The SIM card interface 195 may support a nano-SIM card, a micro-SIM card, a SIM card, or the like. A plurality of cards may be inserted into a same SIM card interface 195 at the same time. The plurality of cards may be of a same type or different types. The SIM card interface 195 is compatible with different types of SIM cards. The SIM card interface 195 is also compatible with an external memory card. The electronic device 100 interacts with a network via a SIM card, thereby implementing functions such as making/answering a call and data communication. In some embodiments, the electronic device 100 uses an eSIM, namely, an embedded SIM card. The eSIM card may be embedded in the electronic device 100, and cannot be separated from the electronic device 100.

A software system of the electronic device 100 may use a layered architecture, an event-driven architecture, a microkernel architecture, a microservice architecture, or a cloud architecture. In embodiments of this application, an Android system with a layered architecture is used as an example to describe the software structure of the electronic device 100.

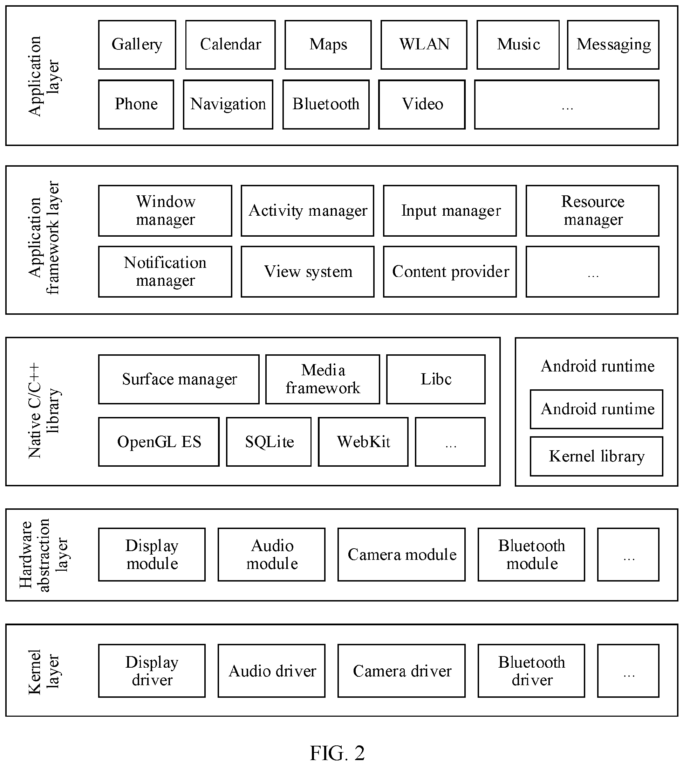

FIG. 2 is a block diagram of a software structure of the electronic device 100 according to this embodiment of this application.

In a layered architecture, software is divided into several layers, and each layer has a clear role and task. The layers communicate with each other through a software interface. In some embodiments, the Android system is divided into five layers: an application layer, an application framework layer, an Android runtime (Android runtime, ART) and a native C/C++ library, a hardware abstraction layer (Hardware Abstraction Layer, HAL), and a kernel layer from top to bottom.

The application layer may include a series of application packages.

As shown in FIG. 2, the application packages may include applications such as Camera, Gallery, Calendar, Phone, Maps, Navigation, WLAN, Bluetooth, Music, Video, and Messaging.

The application framework layer provides an application programming interface (application programming interface, API) and a programming framework for an application at the application layer. The application framework layer includes some predefined functions.

As shown in FIG. 2, the application framework layer may include a window manager, a content provider, a view system, a resource manager, a notification manager, an activity manager, an input manager, and the like.

The window manager provides a window manager service (Window Manager Service, WMS). The WMS may be used for window management, window animation management, surface management, and providing of a transfer station of the input system.

The content provider is configured to store and obtain data, and make the data accessible to an application. The data may include a video, an image, audio, made and received calls, browse history and favorites, a phone book, and the like.

The view system includes visual controls, such as a control for displaying a text and a control for displaying a picture. The view system may be configured to construct an application. A display interface may include one or more views. For example, a display interface including an SMS notification icon may include a text display view and a picture display view.

The resource manager provides, for an application, various resources such as a localized character string, an icon, a picture, a layout file, and a video file.

The notification manager enables an application to display notification information in a status bar, and may be configured to convey a notification-type message. The displayed information may automatically disappear after a short stay, without user interaction. For example, the notification manager is configured to notify a user that downloading is completed, provide a message notification, and the like. The notification manager may alternatively provide a notification, such as a notification of an application running in the background, appearing in a form of a chart or scroll bar text in a top status bar of the system, or may provide a notification appearing in a form of a dialog window on the screen. For example, text information is displayed in the status bar, a prompt sound is played, the electronic device vibrates, or the indicator light blinks.

The activity manager may provide an activity manager service (Activity Manager Service, AMS). The AMS may be used to start, switch, and schedule a system component (for example, an activity, a service, a content provider, or a broadcast receiver), and manage and schedule application processes.

The input manager may provide an input manager service (Input Manager Service, IMS). The IMS may be used to manage a system input, for example, a touchscreen input, a button input, or a sensor input. The IMS obtains an event from an input device node, and allocates the event to an appropriate window by interacting with the WMS.

The Android runtime includes a kernel library and an Android runtime. The Android runtime is responsible for converting source code into machine code. The Android runtime mainly uses an ahead of time (ahead of time, AOT) compilation technology and a just in time (just in time, JIT) compilation technology.

The kernel library is mainly used for providing a basic function of a Java class library, for example, a basic data structure, a math library, an I/O library, a tool library, a database, or a network library. The kernel library provides an API for a user to perform Android application development.

The native C/C++ library may include a plurality of functional modules, for example, a surface manager (surface manager), a media framework (Media Framework), libc, OpenGL ES, SQLite, and WebKit.

The surface manager is configured to manage a display subsystem, and provide fusion of 2D and 3D layers for a plurality of applications. The media framework supports playback and recording in a plurality of common audio and video formats, a static image file, and the like. The media library may support a plurality of audio and video coding formats such as MPEG-4, H.264, MP3, AAC, AMR, JPG, and PNG. The OpenGL ES is used for drawing and operating 2D and 3D graphics in applications. The SQLite provides a lightweight relational database for an application of the electronic device 100.

The hardware abstraction layer runs in a user space (user space), encapsulates a kernel-layer driver, and provides an invoke interface for an upper layer.

The kernel layer is a layer between hardware and software. The kernel layer includes at least a display driver, a camera driver, an audio driver, and a sensor driver.

The following describes an example of a working process of software and hardware of the electronic device 100 with reference to a capture photographing scenario.

When the touch sensor 180K receives a touch operation, a corresponding hardware interruption is sent to the kernel layer. The kernel layer processes the touch operation into an original input event (including information such as touch coordinates, and a time stamp of the touch operation). The original input event is stored at the kernel layer. The application framework layer obtains the original input event from the kernel layer, and identifies a control corresponding to the input event. For example, the touch operation is a single-tap operation; and a control corresponding to the single-tap operation is a control of a camera application icon. A camera application invokes an interface at the application framework layer, to start the camera application. Then, the camera driver is started by invoking the kernel layer, and a static image or a video is captured by using the camera 193.

An embodiment of this application provides a foldable display module. The foldable display module may be used in the electronic device 100.

Having a foldable feature, the foldable display module may be used in the electronic device 100, so that the electronic device 100 is convenient to carry.

The following uses the electronic device 100 as an example for description.

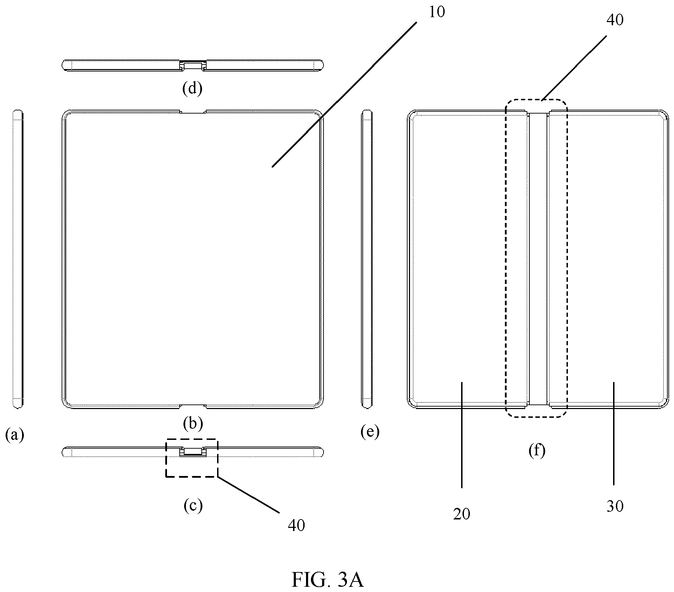

FIG. 3A is a schematic diagram of an unfolded state of an electronic device 100 having a foldable display module according to an embodiment of this application. It should be understood that the electronic device 100 having the foldable display module may be referred to as a foldable electronic device.

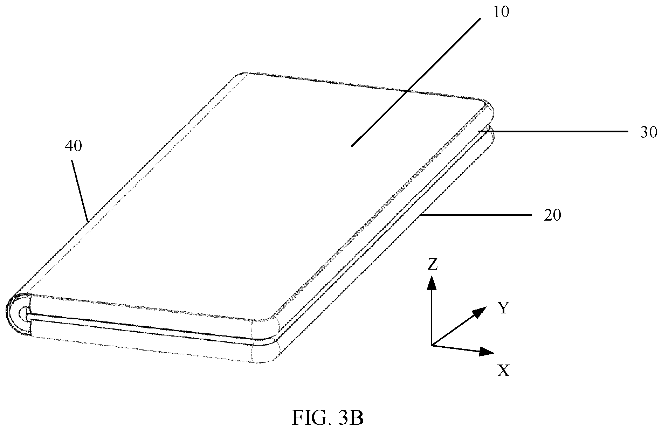

FIG. 3B shows schematic diagrams of appearances of the electronic device 100 from six different angles: a front view (b), a rear view (f), a bottom view (c), a top view (d), a left view (a), and a right view (e). 10 in the front view (b) is the foldable display module of the electronic device. 20 and 30 in the rear view (f) are housings (for example, a first housing 20 and a second housing 30) of the electronic device 100. A dashed-line box in the rear view (f) shows a bendable region 40 of the electronic device 100. It should be understood that, in some embodiments, the electronic device 100 may have a plurality of housings, and there is one bendable region between every two adjacent housings. In some embodiments, the display module of the electronic device 100 may include a plurality of bendable regions, and the bendable regions are continuously distributed (for example, the display module may be a rollable screen).

FIG. 3B is a schematic diagram of a folded state of an electronic device having a foldable display module according to this application. As shown in FIG. 3B, when the two housings rotate to the folded state, the bendable region 40 deforms, and the first housing 20 and the second housing 30 are stacked. In addition, when the first housing 20 is rotatably connected to the second housing 30, a common rotating shaft or another component that can implement rotatable connection may also be used to perform the rotatable connection.

In addition, a coordinate system shown in FIG. 3B is established in this application. A direction x, a direction y, and a direction z are perpendicular to each other. The direction z may be understood as a thickness direction of the electronic device, and the direction y may be understood as an axial direction in the bendable region of the electronic device. The direction x is perpendicular to the direction y, and is parallel to a surface of a flexible screen that is in an unfolded state. All coordinate axes mentioned in this application are based on this coordinate system.

It should be understood that, for any foldable electronic device, the bendable region 40 may alternatively be distributed horizontally (in the direction x); and the display module may be folded along the horizontally distributed bendable region.

In this application, a folding manner shown in FIG. 3A and FIG. 3B is used as an example to describe a foldable-screen support structure, which resolves a bending and arching problem in a folding process of a foldable screen. It should be understood that the foldable-screen support structure provided in this application is also applicable to an electronic device having another folding manner. A screen folding manner is not limited in this application.

In some embodiments, in the unfolded state, the foldable electronic device may be folded in a direction in which front sides of a left screen and a right screen move towards each other. In some embodiments, in the unfolded state, the foldable electronic device may alternatively be folded in a direction in which back sides of a left screen and a right screen move towards each other. This embodiment of this application is described by using an example, shown in FIG. 3B, in which the display module 10 is on a folded outer surface. A folding direction is not limited in this application.

However, after the foldable display module is bent repeatedly, an obvious bending and arching problem occurs, which affects aesthetics of the device and affects user experience. This is mainly because the foldable display module lacks sufficient support. Because a display panel in the foldable display module uses an organic polymer material, and the organic polymer material is stretched when being bent, plastic deformation is formed, and an original state cannot be recovered. Consequently, the foldable display module is bent and arched, which affects user experience.

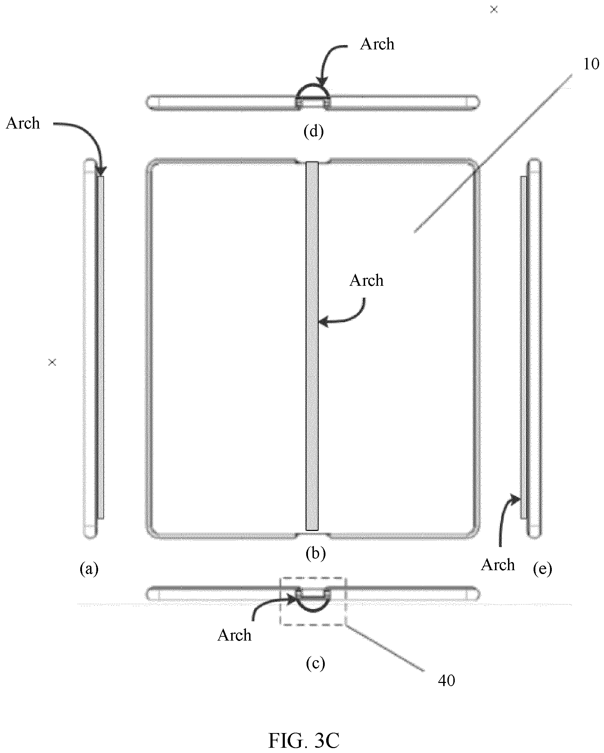

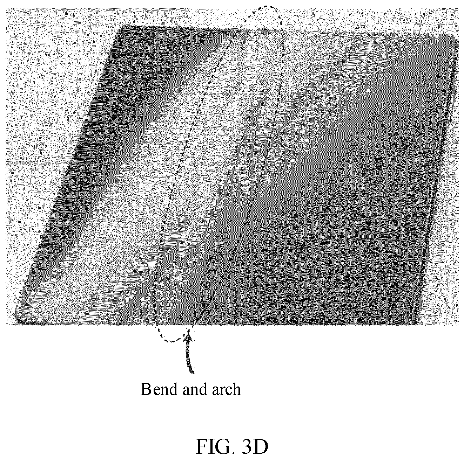

As shown in FIG. 3C and FIG. 3D, bending and arching problems occur after the electronic device 100 having the foldable display module is folded repeatedly. It should be understood that, arch directions and arch positions shown in FIG. 3C and FIG. 3D are illustrative instead of representing a specific limitation on the arch directions and the arch positions.

The bending and arching problems of the foldable display module become a challenge in the industry, and seriously affect an appearance and reliability of a foldable mobile phone.

Some terms are explained before embodiments of this application are described.

In this embodiment, a functional layer is a layer (for example, a cover plate, a polarizer, a touch layer, a display panel, ultra-thin glass, a back film, or a metal support structure) that belongs to a screen module and that is different from a sticking layer (for example, a first sticking layer and a second sticking layer in FIG. 4).

In this embodiment, the ultra-thin glass can be used in a complex structure, is incomparable by common glass, and has advantages such as high-temperature resistance, corrosion resistance, high light transmittance, a flat surface, high hardness, good chemical stability, and a wide application range. In some embodiments, a thickness of the ultra-thin glass may range from 0.03 mm to 0.5 mm. In this embodiment of this application, a same functional layer or a same sticking layer may be divided into a light-emitting side surface and a backlight side surface in a stacking direction (for example, up-down stacking) of the display module. The "light-emitting side surface" described in this embodiment is a surface that is of a functional layer or a sticking layer and that is closer to an outer surface (a surface that can directly interact with a user, for example, a surface 101 shown in FIG. 4) of the display module when the display module is of a stacked structure. For example, as shown in FIG. 4, the cover plate 2011 may include a light-emitting side surface 2011-2 and a backlight side surface 2011-1.

It should be further understood that, when the display module is of an up-down stacked structure, a same functional layer or a same sticking layer may be divided into a direction of a light-emitting side and a direction of a backlight side. In this embodiment of this application, the direction of the light-emitting side is an upper side, and the backlight side is a lower side. For example, as shown in FIG. 4, the first sticking layer A1 has a light-emitting side and a backlight side. The cover plate is on the light-emitting side of the first sticking layer A1. An additional layer 2012 is on the backlight side of the first sticking layer A1.

In an embodiment, ultra-thin glass may be directly placed on two sides of the display panel. It should be understood that "directly placed on two sides of the flexible display panel" herein means that there is only a sticking layer between the ultra-thin glass and the flexible display panel, and there is no other functional layer. For example, as shown in FIG. 4, the ultra-thin glass may be directly placed on the upper and lower sides of the flexible display panel. It should be further understood that "on two sides of the display panel" means that the ultra-thin glass is on the upper and lower sides of the display panel, and that the ultra-thin glass and the display panel present a stacked structure.

FIG. 4 is a sectional view of a display module 10 of an electronic device 100 in an unfolded state. The display module 10 may include a bendable region, a first non-bendable region, and a second non-bendable region. It should be understood that positions and quantities of the bendable region and the non-bendable regions are illustrative instead of representing a limitation on a specific structure of the display module 10. In some embodiments, the bendable region may be referred to as a folding region, the first non-bendable region may be referred to as a first region, and the second non-bendable region may be referred to as a second region. The first region and the second region may be folded or unfolded along the folding region.

It should be further understood that in this embodiment of this application, the display module may also be referred to as a display apparatus.

The display module 10 of the electronic device 100 may be of a stacked structure comprises a plurality of the following layers and a combination thereof: Layer 2011: Cover plate Layer A1: First sticking layer
Layer 2012: Additional cover plate
Layer A2: Second sticking layer
Layer 204: Polarizer
Layer A3: Third sticking layer
Layer 2031: Ultra-thin glass
Layer A4: Fourth sticking layer
Layer 205: Display panel
Layer A6: Sixth sticking layer
Layer 2032: Ultra-thin glass
Layer A5: Fifth sticking layer
Layer 207: Back film layer
Layer A7: Sixth sticking layer
Layer 208: Support structure

The layer 2011 is the cover plate, and may also be referred to as a protective layer in some embodiments. A name of the layer 2011 is not specifically limited in embodiments of this application. The cover plate can protect the display module 10 from being scratched. The cover plate may be a film made of a plastic material PET (Polyethylene Terephthalate, polyethylene terephthalate). Because the PET film is prone to plastic deformation in a long-term bending process, in some embodiments, the cover plate may alternatively be made of clear polyimide (CPI, clear Polyimide). Compared with a PET film, a CPI film may provide a higher strain value and can resist a higher temperature. In some embodiments, the cover plate may alternatively be ultra-thin glass (UTG, Ultra-Thin Glass). In some embodiments, a hard coating HC (Hard Coating) (not shown in the figure) may be further added to the cover plate, so as to obtain effects of high light transmittance, low haze, friction resistance, availability at a high temperature/high humidity/high atmospheric pressure, a low possibility of breaking, and high flexibility. In some embodiments, a material of the layer 2011 may alternatively be ultra-thin glass.

In some embodiments, the display module 10 may further include the layer 2012. The layer 2012 may be referred to as an additional layer, used for enhancing impact resistance of a screen. For material selection of the additional layer 2012, refer to the content of the cover plate 2011. Details are not described herein again.

The cover plate is stuck to the additional layer by using the first sticking layer A1 (for example, optically clear adhesive, pressure-sensitive adhesive, or thermally reactive adhesive).

The layer 204 is a polarizer (for example, a polarizing plate). The polarizer may allow non-polarized light to pass through and block polarized light. Moreover, the polarizer may convert, into polarized light, the non-polarized light passing through the polarizer. Natural light that is incident into the display module from the outside is non-polarized light, and becomes polarized light after passing through the polarizer. After being reflected by an obstacle (for example, the ultra-thin glass 2031 or the display panel 205), the polarized light is blocked by the polarizer. Therefore, the polarizer can effectively block light that is from natural light and that is reflected by an obstacle and propagated outside the layer 2011, thereby performing a function of cutting off ambient light reflection, and improving user experience. In some embodiments, the polarizer may be a metal polarizing plate, an iodine-based polarizing plate, a dye-based polarizing plate, a polyvinyl polarizing plate, or the like. A type of the polarizer is not specifically limited in this embodiment. In some embodiments, the polarizer may be a coatable polarizing plate. When the coatable polarizing plate is used, a thickness of the display module can be effectively reduced. Therefore, bending performance is improved. A thickness of the polarizing plate may be reduced from 67 um to 5 um by using the coatable polarizing plate. In some embodiments, the polarizer may be a circular polarizing plate.

In some embodiments in which the additional layer 2012 exists, the polarizer 204 may be stuck to the additional layer 2012 by using the second sticking layer A2 (for example, optically clear adhesive, pressure-sensitive adhesive, or thermally reactive adhesive). In some embodiments, the display module 200 may not include the additional layer 2012; and the polarizer 204 may be stuck to the cover plate 2011 by using the first sticking layer A1 or the second sticking layer A2 (for example, optically clear adhesive, pressure-sensitive adhesive, or thermally reactive adhesive).

The ultra-thin glass has a good bendable feature, is scratch-resistant, water-resistant, and oxygen-resistant, and has good heat resistance, high light transmittance, and specific surface hardness. Therefore, the ultra-thin glass can provide a support force while meeting a bending requirement. In addition, the ultra-thin glass having an ultra-thin feature may also reduce the thickness of the display module.

The ultra-thin glass 2031 may be stuck to a backlight side surface of the polarizer 204 by using the third sticking layer A3 (for example, optically clear adhesive, pressure-sensitive adhesive, or thermally reactive adhesive). In some embodiments, a thickness of the third sticking layer A3 is about 50 um, to provide a better sticking force. In some embodiments, the third sticking layer A3 may be sticking glue having a low shear stress value. This can enhance foldable bending performance of the display module, and avoid damage to the display module during folding. It should be understood that the shear stress value is used to measure tensile performance of the third sticking layer. If the shear stress value is small, it indicates that the third sticking layer has relatively good tensile performance.

In some embodiments, the ultra-thin glass 2031 may be stuck to a light-emitting side surface of the display panel 205 by using the fourth sticking layer A4 (for example, optically clear adhesive, pressure-sensitive adhesive, or thermally reactive adhesive). For description of the fourth sticking layer A4, refer to the description of the third sticking layer A3. Details are not described herein again.

In some embodiments, the display module may not include the ultra-thin glass 2031; and the polarizer may be stuck to the display panel by using the third sticking layer A3 and/or the fourth sticking layer A4.

The display module 10 includes the display panel 205.

In some embodiments, the display panel 205 may be a flexible OLED (Organic Light-Emitting Diode) display panel. In some embodiments, the display panel 205 may be a flexible OLCD (Organic Liquid-Crystal Display) display panel. The following uses a flexible OLED display panel as an example for description. As shown in FIG. 5A, a structure of the flexible OLED display panel may include a substrate 2051, a drive circuit layer 2052, an organic light-emitting component layer 2053, an encapsulation layer 2054, and an encapsulation protecting layer 2055. The substrate 2051 may provide good water and oxygen blocking performance for the organic light-emitting component layer, thereby preventing an OLED organic material from failing due to a reaction that easily occurs when the OLED organic material meets water and/or oxygen. In some embodiments, the substrate 2051 may be made of a material such as a PI (Polyimide, polyimide) film or a PET (Polyethylene Terephthalate, polyethylene terephthalate) film. In some embodiments, the organic light-emitting component layer 2053 may be an active matrix organic light emitting diode AMOLED (Active Matrix Organic Light Emitting Diode). In some embodiments, the drive circuit layer 2052 may be a thin film transistor (Thin Film Transistor, TFT for short) array. The TFT array determines which pixels in the AMOLED emit light, so as to generate an image. In some embodiments, the TFT array may be an improved conventional amorphous silicon technology (a-Si TFT), or may be a low temperature poly-silicon technology (LTPS TFT, Low Temperature Poly-silicon Thin Film Transistor) with high carrier mobility, or may be an organic thin film transistor (OTFT).

In some embodiments, the organic light-emitting component layer 2053 may alternatively be a passive matrix organic light emitting diode PMOLED (Passive Matrix Organic Light Emitting Diode). The encapsulation layer 2054 may encapsulate the PMOLED to block water and oxygen, thereby preventing water and oxygen from entering the PMOLED and then making the PMOLED fail. In some embodiments, the flexible OLED display panel may further include an encapsulation protecting layer; and the encapsulation protecting layer is on a light-emitting side of the flexible OLED display panel. The encapsulation protecting layer 2055 may protect the organic light-emitting component layer 2053 and the encapsulation layer 2054, to prevent stress and deformation caused by bending of the screen.

In some embodiments, there may also be the touch layer between the encapsulation protecting layer 2055 and the encapsulation layer 2054, as shown in FIG. 5B. In some embodiments, the touch layer 209 may be a resistive touch layer, a capacitive touch layer, a surface acoustic wave-type touch layer, or a light wave-type touch layer. In some embodiments, the touch layer 209 may be a touch grid pattern formed by a conductive material. For example, the conductive material may be metal, metal oxide, graphene, or the like.

The touch layer is integrated into the display panel, so that a thickness of a foldable-screen display module can be effectively reduced. Moreover, damage to the display module can be avoided during bending.

In some embodiments, the touch layer may be integrated with built-in ultra-thin glass. Compared with a touch layer integrated with built-in PET, a touch layer integrated with ultra-thin glass may have a better drop ball-resistance capability and a better strain force, which can avoid damage during bending.

In some embodiments, the touch layer may be an add-on touch layer. In some embodiments, the add-on touch layer may be alternatively placed on the light-emitting side of the display panel 205 shown in FIG. 4, and a backlight side (not shown in the figure) of the ultra-thin glass 2031. The add-on touch layer is placed on the backlight side of the ultra-thin glass 2031, so that protection for the add-on touch layer can be enhanced by using a drop ball-resistance performance property of the ultra-thin glass. In some embodiments, the add-on touch layer may be placed on a light-emitting side (not shown in the figure) of the ultra-thin glass 2031 shown in FIG. 4. For example, the add-on touch layer may be placed on a light-emitting side of the ultra-thin glass 2031, and a backlight side of the polarizer 204. The add-on touch layer may be placed on the backlight side of the polarizer 204, so that reflection of ambient light irradiated to the add-on touch layer can be cut off, thereby improving user experience.

In some embodiments, the add-on touch layer may alternatively be on a light-emitting side of the polarizer 204, and a backlight side of the cover plate 2011.

The touch layer is placed on the light-emitting side of the polarizer 204, so that the touch layer is closer to the cover plate 2011. This enables a user to obtain better touch experience.

In some embodiments, the display module 10 may further include ultra-thin glass 2032. The ultra-thin glass 2032 may be stuck to a backlight side of the display panel 205 by using the sixth sticking layer A6 (for example, foldable optically clear adhesive). For description of the sixth sticking layer A6, refer to the description of the third sticking layer A3. Details are not described herein again. In addition, during bending of the display module, the display panel 205 and the ultra-thin glass 2032 move in a staggered manner. In this case, the sixth sticking layer A6 can further avoid damage to the display panel 205 caused by excessive slipping.

The ultra-thin glass 2031 and the ultra-thin glass 2032 are directly placed on the upper and lower sides of the display panel, so that the ultra-thin glass can well support the display panel, thereby effectively avoiding a bending and arching problem caused by plastic deformation of an organic polymer material in the display panel after bending of the display module.

The ultra-thin glass is stuck to the display panel by using the foldable optically clear adhesive, so that damage to the display panel caused by excessive slipping between the ultra-thin glass and the display panel during bending can be avoided, thereby protecting the display panel.

The layer 207 is a back film, used for supporting the flexible display panel 205. In some embodiments, a material of the back film 207 may include any one of the following polymer film materials: PI (Polyimide, polyimide), PET (Polyethylene Terephthalate, polyethylene terephthalate), and TAC (Triacetyl Cellulose, triacetyl cellulose). In some embodiments, a material of the back film 207 may alternatively be another flexible material.

In some embodiments, the back film may be an LCP (Liquid Crystal Polymer, liquid crystal polymer) film.

Because the LCP film has greater mechanical strength than a PI film, the display panel can be better supported, to reduce an arching problem caused by repeated bending of the foldable display module.

In some embodiments, the back film 207 is stuck to the ultra-thin glass 2032 by using the fifth sticking layer A5 (for example, optically clear adhesive).

The layer 208 is a support structure that may include a hollowed-out region and a non-hollowed-out region, as shown in FIG. 6. It should be understood that, in some embodiments, a hollowed-out structure may also be referred to as a bamboo book structure. In some embodiments, the layer 208 may be a metal structure (for example, the layer 208 includes a metal hollowed-out region and a metal non-hollowed-out region). It should be understood that, in some embodiments, a pattern of the hollowed-out region may be another pattern (for example, the hollowed-out pattern may be one or a combination of a plurality of shapes such as a rectangle, a triangle, and a circle). The pattern of the hollowed-out region is not specifically limited in this embodiment of this application. Optionally, a thickness of the layer 208 ranges from 50 um to 200 um.

A hollowed-out structure is used in the bendable region, and a non-hollowed-out structure is used in the non-bendable region to support the display module. Therefore, on the premise that a requirement for a bendable feature is met, a strong support force can be provided for the display module. This reduces a bend and arch degree, and increases flatness of the display module that is unfolded after folding.

In some embodiments, a conformal antenna may be placed on a backlight side of the hollowed-out structure of the layer 208. The conformal antenna may be formed by an electricity conducting track sprayed on a flexible circuit board. Optionally, the antenna may include one or more directional antennas or omni-directional antennas. For example, the antenna may include a dipole antenna, a monopole antenna, a patch antenna, a loop antenna, a slot antenna, or another type of antenna that is suitable for transmission of a radio frequency signal. Optionally, a substrate material of the flexible circuit board is an LCP (Liquid Crystal Polymer, liquid crystal polymer).

The metal hollowed-out structure may be used as a metal cavity that can improve a radiation gain of the conformal antenna.

Because the LCP is used as the substrate material of the flexible circuit board, and a loss tangent value of an LCP film is less than that of a PI film used in a conventional flexible circuit board, a loss of antenna radiation can be reduced. In addition, because the LCP has strong mechanical strength and high-temperature resistance, it can be ensured that bending can be prevented from damaging the antenna or shortening the service life of the antenna.

In some embodiments, a transparent antenna may be placed in the non-bendable region. Optionally, the transparent antenna may be a conductive thin-film antenna. It should be understood that, the transparent antenna may be placed on a light-emitting side of the touch layer. Optionally, a ground terminal of the transparent antenna may be a metal housing of the display module or a metal support structure 208.

The back film 207 may be stuck to the support structure 208 by using the sixth sticking layer A6 (for example, optically clear adhesive or pressure-sensitive adhesive).

In some embodiments, a buffer (not shown in the figure) may also be included between the back film 207 and the support structure 208. The buffer is used for shock absorption and buffering. A material of the buffer may be foam and/or copper foil. In some embodiments, the material of the buffer may include graphite, to improve a heat dissipation effect of the display module. In some embodiments, a support component may also be included between the back film 207 and the support structure 208. The support component may be at least one of a SUS (Steel Use Stainless) steel sheet (for example, a steel sheet having a thickness is 30 um), a copper sheet, or an aluminum sheet. In some embodiments, the support component may alternatively be made of an alloy material. The support component has a relatively high elastic modulus, thereby fulfilling a supporting function, and reducing a crease caused by bending.

In some embodiments, a metal support component is included between the back film 207 and the support structure 208; and the sixth sticking layer A6 may be a film made of epoxy resin adhesive or hot melt adhesive. Because both the metal support structure 208 and the metal support component (for example, the SUS steel sheet) are metal structures, the sixth sticking layer using the film made of the epoxy resin adhesive or the hot melt adhesive can implement firmer sticking. Moreover, a horizontal stripe caused by the foldable fifth sticking layer in the metal hollowed-out region can be avoided, so that the display module is kept flat.

In some embodiments, for better heat dissipation, a heat dissipation layer (not shown in the figure) may also be included between the back film 207 and the support structure 208. The heat dissipation layer is stuck to the back film 207 by using any one of the first sticking layer A1, the second sticking layer A2, the third sticking layer A3, the fourth sticking layer, the fifth sticking layer, and the sixth sticking layer. In some embodiments, a material of the heat dissipation layer may be graphene. In some embodiments, a protective layer may be placed under the heat dissipation layer to protect the heat dissipation layer. A material of the protective layer may be PET.

In another embodiment of this application, as shown in FIG. 7, the ultra-thin glass 2031 may be placed on the light-emitting side of the polarizer 204; and the ultra-thin glass 2032 may be placed on a backlight side of the back film 207. A difference from the embodiment in FIG. 4 lies in that positions of the ultra-thin glass 2031 and the polarizer 204 are exchanged, and that positions of the ultra-thin glass 2032 and the back film 207 are exchanged. For content (such as a material, a position, and a beneficial effect) of another layer, refer to the content of the embodiment in FIG. 4. Details are not described herein again.

The ultra-thin glass is placed on a light-emitting side of a polarizing plate, so that drop ball-resistance performance of the screen module can be enhanced.

The ultra-thin glass is placed on the backlight side of the back film, and both the ultra-thin glass and the back film support the display panel, so that a support force can be provided for the display panel more effectively, to reduce a bending and arching problem caused by repeated bending of the foldable display module.

The support structure 208 is under the ultra-thin glass 2032. For description of the support structure 208, refer to related content of the embodiment in FIG. 4.

The ultra-thin glass 2032 is stuck to the support structure 208 by using the sixth sticking layer (for example, optically clear adhesive). For description of the sixth sticking layer, refer to related content of the embodiment in FIG. 4.

In some embodiments, a buffer may also be included between the ultra-thin glass 2032 and the support structure 208; and an SUS steel sheet (not shown in the figure) may also be included between the ultra-thin glass 2032 and the metal support structure 208. The SUS steel sheet has a relatively high elastic modulus, thereby reducing a crease caused by bending.

Optionally, in some embodiments, for better heat dissipation, a heat dissipation layer may also be included between the ultra-thin glass 2032 and the support structure 208. The heat dissipation layer is stuck to the back film by using optically clear adhesive. A material of the heat dissipation layer may be graphene. A protective layer may be placed under the heat dissipation layer to protect the heat dissipation layer. A material of the protective layer may be PET.

Experiments show that a flattened angle, after static bending, of a display module that does not use ultra-thin glass is 70°. After a first piece of ultra-thin glass is used above a display panel, and a second piece of ultra-thin glass is used under the display panel, a flattened angle after static bending is 100°.

Further, a sticking layer (for example, foldable optically clear adhesive) having a specific refractive index may be selected in the foregoing embodiment. A large amount of an organic polymer film material, for example, CPI is used in the foldable display module, where a refractive index of the CPI is 1.6. However, a refractive index of an existing sticking layer is mainly 1.47, which does not match a refractive index of another organic polymer film material. As a result, reflectivity of each boundary surface of stacked layers of a display module increases, a transmittance degree decreases, and light-emitting efficiency of the display module is greatly affected. Optionally, a sticking layer having a refractive index of 1.5 is selected, so that light transmittance of the display module can be greatly improved, and optical reflectivity of the display module can be reduced. Optionally, a value of the refractive index of the sticking layer ranges from 1.5 to 1.8. In some embodiments, for the sticking layers in the foregoing embodiment, the refractive indexes of the sticking layers may be different.

Further, a thickness of the sticking layer (for example, foldable optically clear adhesive) may be increased (for example, to be not less than 15 um) in the foregoing embodiment. A shear stress value can be reduced by increasing the thickness of the sticking layer, so as to enhance foldable bending performance of the display module, and avoid damage to the display module during folding. Optionally, the thickness of the sticking layer ranges from 15 um to 45 um. In some embodiments, the thickness of the sticking layer may be 75 um, 100 um, 125 um, or 150 um.

When the sticking layer having the thickness of 15 um to 45 um is used, foldable bending performance of the display module can be enhanced without significantly increasing a thickness of the display module. This maintains good user experience.

When the sticking layer having the thickness of 75 um, 100 um, 125 um, or 150 um is used, foldable bending performance of the display module can be enhanced without significantly increasing a thickness of the display module. This maintains good user experience.

In some embodiments, the sticking layer (for example, foldable optically clear adhesive) has different thicknesses in the bendable region and the non-bendable region. Optionally, the thickness of the sticking layer in the bendable region is greater than the thickness of the sticking layer in the non-bendable region. Optionally, the thicknesses of the sticking layer change gradually in the bendable region and the non-bendable region. For example, a thickness of the sticking layer is larger at a position closer to the bendable region. Optionally, the thicknesses of the sticking layer change in a stepped manner from the bendable region to the non-bendable region.

When the sticking layer having different thicknesses in the bendable region and the non-bendable region is used, foldable bending performance of the display module can be enhanced without significantly increasing a thickness of the display module. This maintains good user experience.

When the sticking layer whose thicknesses change gradually in the bendable region and the non-bendable region is used, shear stress can change gradually in the bendable region and the non-bendable region. This avoids damage to a display module caused by a sudden change of stress on the display panel in the bendable region and the non-bendable region during folding of the foldable display module.

Further, a sticking layer (for example, foldable optically clear adhesive) having a low elastic modulus may be used in the foregoing embodiment. The sticking layer having the low elastic modulus has a low shear stress value, so that foldable bending performance of the display module can be enhanced, and damage to the display module during folding can be avoided.

In some embodiments, an elastic modulus of the sticking layer may range from 15 Kpa to 100 Kpa.

Preferably, the elastic modulus of the sticking layer is 30 Kpa, 45 Kpa, or 50 Kpa.

The sticking layer having the elastic modulus of 30 Kpa, 45 Kpa, or 50 Kpa is used, so that foldable bending performance of the display module is enhanced. Moreover, a bonding force of the sticking layer can be maintained, so that a bonding function can be implemented better to avoid a phenomenon that a functional layer of the display module falls off due to insecure bonding.

Further, in the foregoing embodiment, the display panel and the sticking layers on the upper and lower sides of the display panel present a stacked structure. The elastic modulus of the sticking layer on one side (for example, the backlight side) of the display panel is different from the elastic modulus of the sticking layer on the other side (for example, the light-emitting side) of the display panel. In some embodiments, a difference between the elastic modulus of the sticking layer on the one side (for example, the backlight side) of the display panel and the elastic modulus of the sticking layer on the other side (for example, the light-emitting side) of the display panel is less than 10 Kpa.

The sticking layers having different elastic moduli are used on the two sides of the display panel, so that foldable bending performance of the display module can be enhanced. Moreover, a support force required for recovering a flattened state after bending of the display module can be provided.

In some embodiments, the sticking layers having different elastic moduli may be used in the bendable region and the non-bendable region. Optionally, the elastic modulus of the sticking layer in the bendable region is less than the elastic modulus of the sticking layer in the non-bendable region.

In some embodiments, a sticking layer having gradually changed elastic moduli may be used (for example, an elastic modulus of the sticking layer is smaller at a position closer to the bendable region; or the elastic moduli of the sticking layer gradually change in a thickness direction). Optionally, the elastic modulus of the sticking layer in the bendable region is less than the elastic modulus of the sticking layer in the non-bendable region.

The sticking layers having different elastic moduli are used in the bendable region and the non-bendable region, so that foldable bending performance of the display module can be enhanced. Moreover, a support force required for recovering a flattened state after bending of the display module can be provided.

It should be understood that the sticking layer in this embodiment of this application may be foldable optically clear adhesive.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable display apparatus, wherein the foldable display apparatus comprises:
a display panel;
first ultra-thin glass and second ultra-thin glass that are stacked on two sides of the display panel;
a first sticking layer between the display panel and the first ultra-thin glass; and
a second sticking layer between the display panel and the second ultra-thin glass, wherein
a stacked structure comprising the first ultra-thin glass, the first sticking layer, the display panel, the second sticking layer, and the second ultra-thin glass is divided into a first region, a second region, and a folding region, wherein the folding region is between the first region and the second region, and the first region and the display region are folded or unfolded along the folding region; and
elastic moduli of the first sticking layer and the second sticking layer range from 15 Kpa to 100 Kpa.

2. The foldable display apparatus according to claim 1, wherein thicknesses of the first sticking layer and the second sticking layer range from 15 um to 45 um.

3. The foldable display apparatus according to claim 1 or 2, wherein the elastic modulus of the first sticking layer is different from the elastic modulus of the second sticking layer.

4. The foldable display apparatus according to claim 3, wherein the foldable display apparatus further comprises a third sticking layer and a back film that are stacked on a same side of the display panel, wherein
both the third sticking layer and the back film are between the display panel and the first ultra-thin glass; and
the third sticking layer is between the back film and the first ultra-thin glass.

5. The foldable display apparatus according to claim 4, wherein the foldable display apparatus further comprises:
a fourth sticking layer and a polarizer that are stacked on a same side of the display panel, wherein
both the fourth sticking layer and the polarizer are between the display panel and the second ultra-thin glass; and
the fourth sticking layer is between the polarizer and the second ultra-thin glass.

6. The foldable display apparatus according to claim 4 or 5, wherein the foldable display apparatus further comprises:
a touch layer and a fifth sticking layer that are stacked on a same side of the display panel, wherein
the touch layer and the fifth sticking layer are between the second ultra-thin glass and the polarizer; and
the fifth sticking layer is between the second ultra-thin glass and the touch layer.

7. The foldable display apparatus according to claim 4 or 5, wherein the display panel comprise an encapsulation layer, an organic light-emitting component layer, and a touch layer, wherein the encapsulation layer, the organic light-emitting component layer, and the touch layer form a stacked structure.

8. The foldable display apparatus according to claim 6 or 7, wherein the touch layer comprise third ultra-thin glass.

9. The foldable display apparatus according to claim 8, wherein values of refractive indexes of the first sticking layer, the second sticking layer, the third sticking layer, the fourth sticking layer, and the fifth sticking layer range from 1.5 to 1.8.

10. The foldable display apparatus according to claim 9, wherein the polarizer is a coatable polarizing plate, or the first sticking layer, the second sticking layer, the third sticking layer, the fourth sticking layer, and the fifth sticking layer are foldable optically clear adhesive.

11. The foldable display apparatus according to claim 10, wherein the polarizer is a circular polarizing plate.

12. A foldable electronic device, wherein the foldable electronic device comprises the foldable display apparatus according to any one of claims 1 to 11.
